# EUROPEAN PATENT APPLICATION

(11) **EP 2 857 741 A2**
(43) Date of publication of application: **08.04.2015**
(21) Application number: 14185984.3
(22) Date of filing: 23.09.2014
(51) Int. Cl.: F21S 8/10, F21K 99/00

(54) **Red lamp and vehicle lighting fixture**

(30) Priority: 26.09.2013 JP 2013200175
(71) Applicant: Shin-Etsu Chemical Co., Ltd., Chiyoda-ku Tokyo (JP)
(72) Inventor: Tsumori, Toshihiro, Echizen-shi, Fukui (JP); Wataya, Kazuhiro, Echizen-shi, Fukui (JP); Tsukatani, Toshihiko, Echizen-shi, Fukui (JP); Minowa, Takehisa, Echizen-shi, Fukui (JP)
(74) Representative: Stoner, Gerard Patrick

(57) **Abstract**

A red lamp is provided comprising a blue LED array (11) and a red emissive member (12). The red emissive member (12) is made of a resin having dispersed therein a phosphor capable of absorbing blue light and emitting red light, the phosphor being selected from among silicate, SiAlON, silicon nitride, sulfide, and garnet structure phosphors. The red lamp offers high efficiency, high light intensity, and improved visibility both in front and lateral directions and is thus suited for use in vehicle lighting fixtures such as red rear position lamps and red stop lamps.

## Description

### TECHNICAL FIELD

This invention relates to vehicle lighting fixtures, typically red rear position lamps and red stop lamps, mounted at the rear of every vehicle for producing red light backward for alerting braking or enhancing the visibility at night, and red lamps for use therein.

### BACKGROUND

Vehicles are fitted at the rear with lighting fixtures, typically red rear position lamps and red stop (brake) lamps, for producing red light rearwardly in response to braking and lighting switches for alerting to braking or enhancing visibility at night. In most prior art rear position lamps and stop lamps, incandescent bulbs, halogen bulbs, and HID lamps are generally used and combined with covers of red-colored light-transmitting resin to produce red light. Recently, there are known rear position lamps and stop lamps having a plurality of red LED chips arrayed therein.

When incandescent bulbs, halogen bulbs, and HID lamps are used as the light source, they emit light containing red component and many other color components. Typically red light is obtained by passing overall light through covers of red color light-transmitting material or resin to cut off the other color components. This entails the drawback that while the light source emits a wide spectrum of light, the energy of light components other than red light is wasted.

On the other hand, rear position lamps and stop lamps utilizing red LEDs have some drawbacks. Since the emission efficiencies of red LEDs are generally not so high, a greater number of red LEDs must be used in order to ensure sufficient visibility. Also, red LEDs produce highly directional emission, which ensures high visibility straight ahead of the lamp (along the optical axis of the lamp), but leads to very low visibility from a lateral side of the lamp (in directions off the optical axis of the lamp). Attempts to mitigate these drawbacks were made by combining red LEDs with reflectors and lenses of different shape and material. However, it is still difficult to manufacture a red lamp using red LEDs, the red lamp being capable of providing uniform visibility from front and lateral sides of the lamp.

### Citation List

- Patent Document 1:: JP-A 2009-280763
- Patent Document 2:: JP-A 2012-224536 (EP 2508586, US 20120256125)
- Patent Document 3:: JP-A 2009-529154 (WO 2007/103394)

Discussing further: in general, red lighting fixtures for vehicles, typically rear position lamps and stop lamps, are constructed from a light source for lighting, a cover around the light source, reflector, lens, diffuser, decorative member, and the like. They are often integrated with turn signals (indicator lights). As the light source, conventional bulbs are used in the art, but red LEDs are increasingly used nowadays.

The cover surrounding the light source is typically made of thermoplastic resin such as acrylic resin. They are molded to any of widely varying shapes depending on a particular purpose, such as protection of the light source, lens functions of light diffusion and collection, or decoration. The cover members, specifically tail light covers, include red color covers, colorless or white tail light covers, and clear covers in which only the lens portion is colored, known as Euro tail covers. Many reflectors use corner cubes. When illuminated by the headlamp of following vehicles, the reflector reflects light and looks red. It thus has a function of alerting even when the lamps are not lit, when the vehicle is stopped or parked at night.

With respect to these vehicle lighting fixtures, a number of proposals have been made and a variety of models have been used in practice. The basic function of rear position lamps and stop lamps is to alert following vehicles. These lamps operate in response to the headlamp or brake system such that the conventional bulb or red LED is powered to emit white light or red light, which shines rearwardly of the vehicle via a cover, reflector, lens, light diffuser member and the like.

In this case, the illumination from the lamp is basically emission from conventional bulbs or LEDs. Some problems arise with conventional bulbs. Typically their emission is nearly white light. In most cases, color control is thus carried out by passing the emission from the conventional bulb through a red filter member made of resin for cutting off a portion of the emission so that red light is obtained. Since a portion of light that is not transmitted by the red filter member does not exit the lighting fixture, this system is low in utilization efficiency of light energy.

Next, problems associated with the use of red LEDs as the light source are discussed. Since the light quantity from one red LED is relatively small, it is generally necessary to use a plurality of red LEDs at the sacrifice of cost. The red LED light source produces highly directional emission, which ensures high visibility straight ahead of the emission (rearwardly of the vehicle), but leads to the drawback that visibility from a lateral side of the lamp is very low. Thus several measures are taken, for example, by mounting a plurality of red LEDs such that they emit light in different directions, or interposing a highly transparent lens of resin or glass for scattering light from red LEDs. The inclusion of a plurality of red LEDs is expensive. Even when the arrangement of red LEDs is carefully designed, it is difficult to obtain red light having uniform visibility in different directions. The technique of using a highly transparent lens of resin or glass for scattering light from red LEDs is difficult to ensure high visibility in different directions, particularly in lateral direction.

### THE INVENTION

An object of the invention is to provide a red lamp having advantages including low cost, high efficiency, and high visibility not only from the front side of the lamp (in the optical axis of the lamp), but also from a lateral side of the lamp (in a direction off the optical axis of the lamp); and a vehicle lighting fixture comprising the same, such as red rear position lamp or red stop lamp.

The inventors have found that a red lamp providing improved visibility from different directions as required for vehicle lighting fixtures is obtained by using a blue LED array capable of emitting blue light as the light source, and a phosphor capable of absorbing blue light and emitting red component-containing light, whereby blue light is converted to red light serving as illumination light. The phosphor is at least one phosphor selected from among a silicate phosphor, SiAlON phosphor, silicon nitride phosphor, sulfide phosphor, and garnet structure phosphor. A red-emissive member comprising particles of the phosphor in a resin matrix is disposed so as to receive blue light, especially forward in the emission direction of the blue LED. Red light from phosphor particles dispersed in the red-emissive member is projected from the lamp. The lamp offers uniform visibility both from the front side of the lamp and from a lateral side of the lamp, high efficiency, and high light intensity.

Accordingly, the invention provides a red lamp comprising a blue LED array capable of emitting blue light as a light source and a red emissive member adapted to receive the blue light. The red emissive member comprises a resin and a phosphor capable of absorbing blue light and emitting red component-containing light. The phosphor is at least one phosphor selected from the group consisting of a silicate phosphor, SiAlON phosphor, silicon nitride phosphor, sulfide phosphor, and garnet structure phosphor.

The resin is preferably a thermoplastic resin. Preferably the thermoplastic resin is at least one resin selected from the group consisting of a polyethylene, polypropylene, polyester, polystyrene, polycarbonate, ABS resin, and acrylic resin.

Or, the resin may be a thermosetting resin. Preferably the thermosetting resin is at least one resin selected from the group consisting of a phenolic resin, epoxy resin, melamine resin, and urethane resin.

Preferably in said phosphor a silicate phosphor is (Sr,Ca,Ba)₂SiO₄:Eu, a SiAlON phosphor is Ca-α-SiAlON:Eu, a silicon nitride phosphor is (Sr,Ca)AlSiN₃:Eu, a sulfide phosphor is CaGa₂S₄:Eu or a garnet structure phosphor is (Y,Gd)₃Al₅O₁₂:Ce or Y₃Al₅O₁₂:Ce.

Preferably the red lamp, which projects red light along an optical path, further comprises a filter member disposed across the optical path for inhibiting a portion of the blue light from the blue LED array that is transmitted by the red emissive member without being absorbed in the phosphor, from traveling forward in the projection direction of the red lamp.

Preferably the blue LED array is disposed such that the travel direction of blue light along an emission optical axis of the blue LED array is different from the travel direction of red light along a projection optical axis of the red lamp. The red emissive member is disposed at least forward in the travel direction of blue light along the emission optical axis of the blue LED array.

Preferably the red emissive member has an effective region with a thickness of at least 0.5 mm.

In another aspect, the invention provides a vehicle lighting fixture comprising a red lamp defined above. Typically the vehicle lighting fixture is a red rear position lamp or red stop lamp.

As used herein, the term "LED array" refers to a single LED chip and an array of two or more LED chips.

### ADVANTAGEOUS EFFECTS

We find that red lamps proposed herein have advantages including high efficiency, high light intensity, and good or improved visibility both from the front side (ahead) of the lamp and from a lateral side of the lamp. The red lamp is suited for use in a vehicle lighting fixture such as red rear position lamp or red stop lamp.

### BRIEF DESCRIPTION OF DRAWINGS

FIG. 1 schematically illustrates a red lamp in a first embodiment of the invention.
FIG. 2 schematically illustrates a red lamp in a second embodiment of the invention.
FIG. 3 schematically illustrates a red lamp in a third embodiment of the invention.
FIG. 4 schematically illustrates a red lamp in a fourth embodiment of the invention.
FIG. 5 schematically illustrates a red lamp in a fifth embodiment of the invention.
FIG. 6 schematically illustrates a red lamp in a sixth embodiment of the invention.
FIG. 7 schematically illustrates a red lamp in a seventh embodiment of the invention.
FIG. 8 schematically illustrates a red lamp in an eighth embodiment of the invention.
FIG. 9 is a diagram showing an emission spectrum of the red lamp of Example 1.
FIG. 10 is a diagram showing an emission spectrum of the red lamp of Example 2.
FIG. 11 schematically illustrates a red lamp in Comparative Examples 1 and 2.
FIG. 12 is a diagram showing an emission spectrum of the red lamp of Comparative Example 2.

### FURTHER EXPLANATIONS; OPTIONS AND PREFERENCES

The red lamp of the invention comprises a blue LED array capable of emitting blue light as a light source and a red emissive member disposed to receive the blue light. The blue LED array used herein as the light source can have a higher power than red LED arrays.

The blue LED array used as the light source is typically a LED array capable of emitting light having a center wavelength in the range of 420 nm to 490 nm. The size, power and number of blue LED arrays may be appropriately selected by taking into account the light quantity, visibility, alerting function, decoration and other factors of the red lamp. A blue LED array having one emissive chip or a blue LED array having a plurality of emissive chips may be used, alone or in combination of two or more. Such blue LED arrays are commercially available. High-power blue LED arrays are preferred particularly when the red lamp is intended for use in vehicle lighting fixtures such as red rear position lamps and red stop lamps. Preferably the blue LED arrays have a power of at least 0.5 W, especially at least 1 W for each. The total power per red lamp is desirably at least 1 W, especially at least 2 W. Although the upper limit of power is not critical, the power is typically up to 2 W per blue LED array and up to 10 W per red lamp. When a plurality of blue LED arrays are used in combination, preferably at least 2 blue LED arrays, especially 2 to 8 blue LED arrays are incorporated per red lamp.

In the red lamp of the invention, the red emissive member is disposed at a position to receive blue light, specifically forward of the emission direction of the blue LED array. The red emissive member mainly contains a resin and a phosphor capable of absorbing blue light and emitting red component-containing light. The red lamp is constructed such that blue light emitted by the blue LED array is absorbed by the phosphor in the red emissive member and converted to light containing a red component, specifically a red component having a wavelength range of 600 nm to 660 nm, preferably red light, more preferably red light having the maximum intensity in a wavelength range of 600 nm to 660 nm.

The resin of which the red emissive member is made may be either thermoplastic or thermosetting. Of these, thermoplastic resins are preferred for easy control of dispersion of phosphor particles and dimensional stability of the red emissive member. Also, thermoplastic resins are preferred for easy post-working into the desired shape. Further, red emissive members made of thermoplastic resins are not only resistant to cracking by vibration and shocks, that is, vibration resistant and shock resistant, but also weather resistant, indicating that the members are best suited as vehicle-mount members.

Examples of the thermoplastic resin include polyethylene, polypropylene, polyester, polystyrene, polycarbonate, ABS resins, and acrylic resins. Examples of the thermosetting resin include phenolic resins, epoxy resins, melamine resins, and urethane resins. Of these, preference is given to polypropylene and acrylic resins for a good balance of rigidity, hardness and workability. It is preferred from the aspect of utilizing the emitted red component to the maximum that the resins be used in transparent or white color state without coloring.

In the red lamp, a phosphor capable of absorbing blue light and emitting red component-containing light is used as the emissive component (red emissive material) to be mixed with the resin to construct the red emissive member. The phosphor is capable of absorbing blue light, specifically blue light having a wavelength of 420 to 490 nm and emitting light containing a red component having a wavelength in the range of 600 to 660 nm, preferably red light, specifically red light having the maximum intensity in a wavelength range of 600 to 660 nm. According to the invention, the phosphor is at least one phosphor selected from among silicate phosphors, SiAlON phosphors, silicon nitride phosphors, sulfide phosphors, and garnet structure phosphors.

Suitable silicate phosphors include the phosphor of (Sr,Ca,Ba)₂SiO₄:Eu and the like; suitable SiAlON phosphors include the phosphor of Ca-α-SiAlON:Eu and the like; suitable silicon nitride phosphors include the phosphor of (Sr,Ca)AlSiN₃:Eu and the like; suitable sulfide phosphors include the phosphor of CaGa₂S₄:Eu and the like; and suitable garnet structure phosphors include the phosphors of (Y,Gd)₃Al₅O₁₂:Ce and Y₃Al₅O₁₂:Ce and the like.

It is preferred to use, as the red emissive material, a phosphor having an absorptance of 0.3 to 1.0, especially 0.6 to 0.9 with respect to blue light. The phosphor used as the red emissive material is then characterized by a moderate absorptance of blue light which is neither too high nor too low. This can substantially avoid the sometimes inconvenient phenomenon that the majority of blue light emitted by the blue LED as the light source is absorbed by the phosphor in a surface layer (on the blue light incident side) of the red emissive member and little blue light reaches the interior and back layer of the red emissive member. The red emissive member is easily tailored such that an appropriate portion of blue light reaches the interior and back layer of the red emissive member. That is, the phosphor is then very efficient in that all red emissive material particles dispersed in the red emissive member contribute to light emission.

The phosphor may be prepared by any well-known methods. In order to mix the phosphor with the resin and mold the resin compound into a red emissive member, the phosphor should be in particulate form having an appropriate particle size to prevent the inconvenience that blue light is little absorbed and tends to be transmitted by the red emissive member. Specifically, the particulate phosphor preferably has a particle size of at least 2 µm, more preferably at least 5 µm, as expressed by a diameter D50 at 50% by volume cumulative in the particle size distribution. Additionally, the particulate phosphor preferably has a diameter D90 of up to 1,000 µm, more preferably 50 to 500 µm, D90 being a diameter at 90% by volume cumulative in the particle size distribution. If D50 is less than 2 µm, a proportion of scattering may be excessively greater than a proportion of absorption/conversion with respect to the excitation light from blue LED array. Although the maximum of D50 need not be particularly limited, a D50 value of up to 300 µm is preferred from its relationship to the D90 value. Also, if D90 exceeds 1,000 µm, such phosphor particles may interfere with dispersion in the resin during the mixing step.

It is noted that the particle size is preferably measured, for example, by dispersing sample particles in a gas stream and measuring the diameter by the laser diffraction scattering method because the particle size distribution can be evaluated at the same time.

The red emissive member used herein is prepared by mixing the phosphor or red emissive material with the resin and molding the resin compound. By any of well-known molding techniques such as compression molding, extrusion molding and injection molding, the resin compound may be molded to any desired shape such as particulate, bar, film or thin plate and to any desired size, depending on the intended application, shape, and red light projection mode of the red lamp.

Preferably the red emissive member includes an effective region having a thickness of at least 0.5 mm and more preferably up to 10 mm, especially up to 3 mm. If the effective region thickness is less than 0.5 mm, absorption of blue light as excitation light may become insufficient. If the effective region thickness exceeds 10 mm, a drop of emission may be caused by vanishment due to absorption of red component in the red emissive member interior. The effective region refers to a region that contributes to absorption of blue light.

The resin and the phosphor are mixed in a ratio which may vary, depending e.g. on a proportion of activator (typically, Eu or Ce) in the phosphor, on the shape, size, and thickness of the red emissive member, on the relationship of the blue LED to the red emissive member, and the like. Preferably the phosphor is used in an amount of 1 to 60% by weight, more preferably 3 to 40% by weight based on the resin. If the amount of the phosphor is below the range, the absorption of blue light emitted by blue LED may sometimes be low, resulting in shortage of red light, though this depends on the size of the red emissive member. If the amount of the phosphor is beyond the range, the red emissive member may sometimes have low strength because the phosphor is excessive relative to the resin.

Besides the phosphor as the emissive component, an inorganic compound that does not absorb red component, such as silica, alumina or titania, may be added to and dispersed in the resin in order that the red emissive member become in its entirety effective for providing more uniform emission. Also, for the purpose of enhancing weather resistance, the red emissive member may be surface covered with another transparent material having higher weather resistance than the thermoplastic resin used.

Referring to the figures, the structure of the red lamp according to the invention is described.

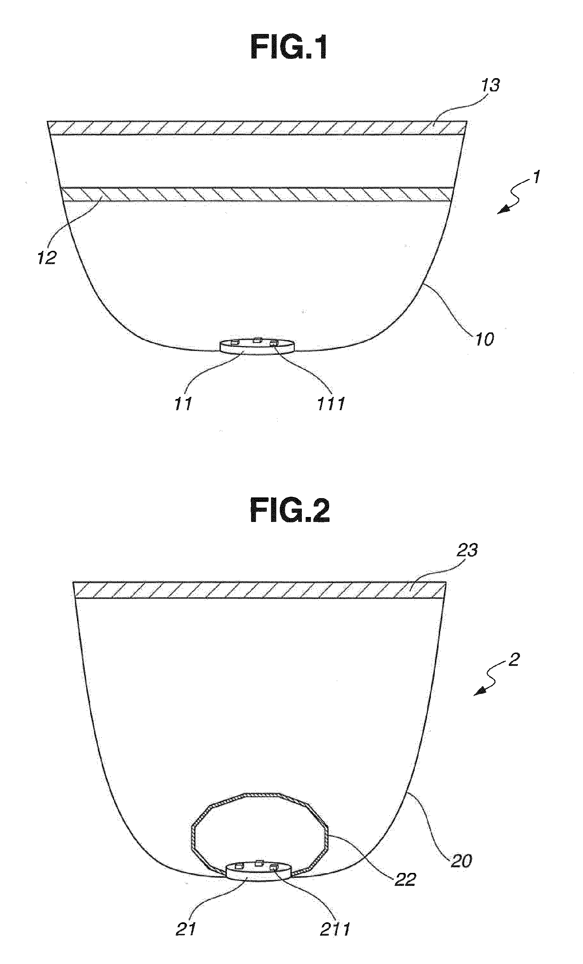

FIG. 1 is a schematic view of a red lamp structure in a first embodiment of the invention. The red lamp 1 includes a base or reflector 10 of generally semi-ellipsoidal shape and a blue LED array 11 disposed on the inner surface of the base 10 and at the back side of the lamp 1 (which is opposite to the projection direction of red light). The blue LED array 11 includes three chips (emissive parts) 111 capable of emitting blue light forward of the lamp (in the projection direction of red light). Notably, the number of chips per LED array is not particularly limited nor the number of blue LED arrays, and this is true to all the following embodiments. The red lamp 1 further includes a red emissive member 12 in plate form disposed at a relatively front side of the lamp 1 (i.e. fitted within the base 10 at an intermediate position) so as to face the blue LED array 11 in the emission direction of blue light and a protective cover 13 in plate form disposed further forward of the red emissive member 12 in the red light projection direction of the red lamp 1 (i.e., fitted within the base 10 at its rim).

The blue LED array 11 emits blue light which enters the red emissive member 12 directly or after reflection by the inner surface of base 10. Blue light incident on the red emissive member 12 is absorbed by the phosphor in the red emissive member 12 and converted thereby to red component-containing light or red light. Red component-containing light or red light exiting the red emissive member 12 travels forward of red lamp 1 directly or after reflection by the inner surface of base 10.

In the illustrated embodiment, the resin and phosphor of which the red emissive member is made are characterized by a low absorptance of red component. Then, even when the red component which is emitted by the red emissive member 12, radiated toward base or reflector 10 and reflected by base 10 enters red emissive member 12 again, little of the red component is absorbed in the red emissive member 12. Therefore, this embodiment has the advantage that the red component is effectively transmitted by the red emissive member 12 and hence, red light is projected forward of the red lamp. The embodiment is especially advantageous for the extraction of red component.

FIG. 2 is a schematic view of a red lamp structure in a second embodiment of the invention. The red lamp 2 includes a base or reflector 20 of generally semi-ellipsoidal shape and a blue LED array 21 disposed on the inner surface of the base 20 and at the back side of the lamp 2 (which is opposite to the projection direction of red light). The blue LED array 21 includes three chips (emissive parts) 211 capable of emitting blue light forward of the lamp (in the projection direction of red light). The red lamp 2 further includes a red emissive member 22 of dome or generally semi-ellipsoidal shape disposed within the base 20 so as to face the blue LED array 21 in the emission direction of blue light and extended so as to confine blue light emitted by the blue LED array 21 and a protective cover 23 in plate form disposed further forward of the red emissive member 22 in the red light projection direction of the lamp 2 (i.e. fitted within the base 20 at its rim).

The blue LED array 21 emits blue light which enters the red emissive member 22 where it is absorbed by the phosphor therein and converted thereby to red component-containing light or red light. Red component-containing light or red light exiting the red emissive member 22 travels forward of the red lamp 2 directly or after reflection by the inner surface of base 20.

In the illustrated embodiment wherein the blue light emitter section is similar to red lamps using conventional incandescent bulbs, halogen bulbs, HID lamps or red LEDs as the light source, one advantage is that the design of prior art red lamps is applicable without substantial changes. Additionally, the lamp of this embodiment produces red light at greater efficiency, higher color purity (or redness), and higher intensity than red lamps using conventional incandescent bulbs, halogen bulbs, HID lamps or red LEDs as the light source. Another advantage is an energy saving as compared with the prior art.

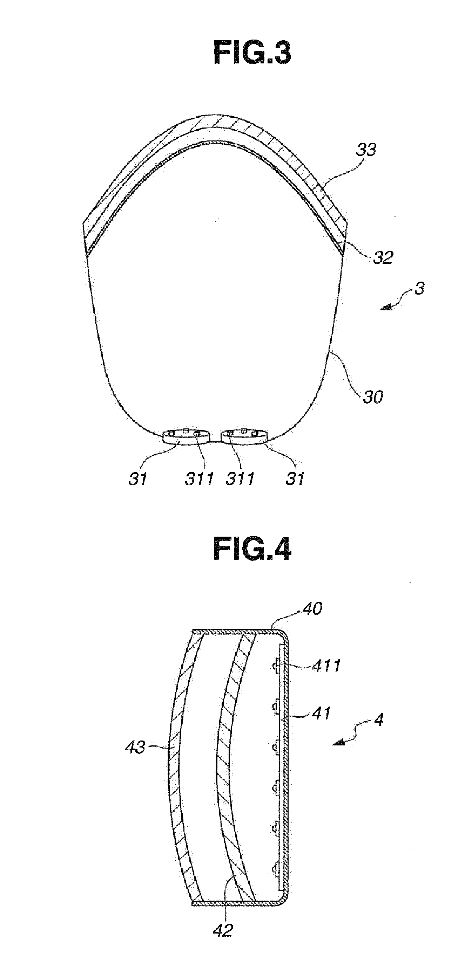

FIG. 3 is a schematic view of a red lamp structure in a third embodiment of the invention. The red lamp 3 includes a base or reflector 30 of generally semi-ellipsoidal shape and two blue LED arrays 31 and 31 disposed on the inner surface of the base 30 and at the back side of the lamp 3 (which is opposite to the projection direction of red light). Each blue LED array 31 includes three chips (emissive parts) 311 capable of emitting blue light forward of the lamp (in the projection direction of red light). The red lamp 3 further includes a red emissive member 32 in plate form of arcuate cross section disposed at the front side of the red lamp 3 (i.e. fitted within the base 10 at its rim) so as to face the blue LED arrays 31 in the emission direction of blue light and a protective cover 33 in plate form of arcuate cross section disposed forward of and adjacent to the red emissive member 32 in the red light projection direction of the red lamp 3 (i.e. fitted within the base 30 at its rim).

The blue LED arrays 31 emit blue light which enters the red emissive member 32 directly or after reflection by the inner surface of base 30. Blue light incident on the red emissive member 32 is absorbed by the phosphor in the red emissive member 32 and converted thereby to red component-containing light or red light. Red component-containing light or red light exiting the red emissive member 32 travels forward of the red lamp 3 directly or after reflection by the inner surface of base 30.

In the illustrated embodiment wherein the red emissive member 32 is of arcuate shape in cross section, good visibility is available in any direction forward of the red lamp 3.

FIG. 4 is a schematic view of a red lamp structure in a fourth embodiment of the invention. The red lamp 4 includes a base or reflector 40 of flat-bottom cylinder shape and a blue LED array 41 disposed on the bottom of base 40 and at the back side of the lamp 4 (which is opposite to the projection direction of red light). The blue LED array 41 includes six chips (emissive parts) 411 capable of emitting blue light forward of the lamp (in the projection direction of red light). The red lamp 4 further includes a red emissive member 42 in plate form of arcuate cross section disposed at a relatively front side of the red lamp 4 (i.e. fitted within the base 40 at an intermediate position) so as to face the blue LED array 41 in the emission direction of blue light and a red filter member 43 in plate form of arcuate cross section disposed forward of the red emissive member 42 in the red light projection direction of the red lamp 4 (i.e. fitted within the base 40 at its rim) so that red component-containing light or red light exiting the red emissive member 42 and red component transmitted by the red emissive member 42 may pass through the red filter member 43.

The blue LED array 41 emits blue light which enters the red emissive member 42 directly or after reflection by the inner surface of base 40. Blue light incident on the red emissive member 42 is absorbed by the phosphor in the red emissive member 42 and converted thereby to red component-containing light or red light. Red component-containing light or red light exiting the red emissive member 42 travels forward of the red lamp 4 directly or after reflection by the inner surface of base 40.

In the illustrated embodiment wherein the filter member is provided across the optical path of red light, the filter member cuts off a portion of blue light emitted by the blue LED array which is transmitted by the red emissive member without absorption in the phosphor, so as to suppress forward projection of blue light in the light projection direction of the red lamp. The filter member is disposed at a position other than the optical path along which blue light travels directly from the blue LED array to the red emissive member

While blue light emitted by the blue LED array is converted to red component by the red emissive member, a portion of blue light may be transmitted by the red emissive member without conversion. Even in this situation, since the red filter member 43 transmits the red component which is emitted from the red emissive member 42 or transmitted through the red emissive member 42, the embodiment is effective for suppressing projection of blue light forward of the red lamp 4. Thus red light of better color purity is obtained. The red filter member may be endowed with a protective cover function.

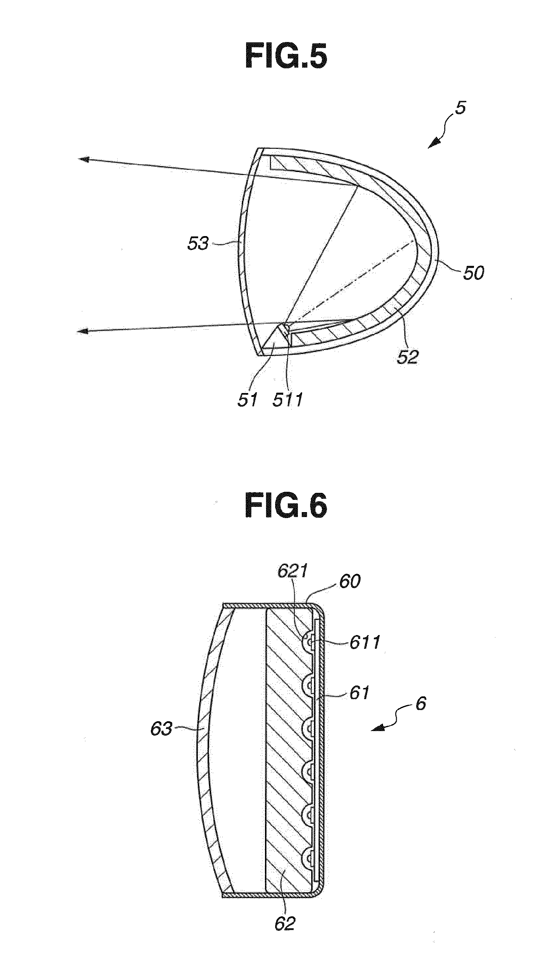

FIG. 5 is a schematic view of a red lamp structure in a fifth embodiment of the invention. The red lamp 5 includes a base or reflector 50 of generally semi-ellipsoidal shape and a blue LED array 51 disposed on the inner surface of the base 50 near its front rim (in the red light projection direction of red lamp 5). The blue LED array 51 includes a chip (emissive part) 511 capable of emitting blue light backward of the lamp (opposite to the projection direction of red light). The red lamp 5 further includes a red emissive member 52 of generally semi-ellipsoidal shape or cap shape disposed on the back side of the red lamp 5 and formed in conformity to the inside of the base 50 and a protective cover 53 in plate form of arcuate cross section disposed further forward of the blue LED array 51 in the red light projection direction of the red lamp 5 (i.e. fitted within the base 50 at its front rim).

The blue LED array 51 emits blue light which enters the red emissive member 52 directly or re-enters the red emissive member 52 after reflection by the inner surface of base 50 when transmitted by the red emissive member 52. Blue light incident on the red emissive member 52 is absorbed by the phosphor in the red emissive member 52 and converted thereby to red component-containing light or red light. The resulting red component-containing light or red light travels forward of the red lamp 5 directly or after reflection by the inner surface of base 50. In FIG. 5, arrows indicate some exemplary rays.

In the illustrated embodiment, the blue LED array is arranged such that the travel direction of blue light along the emission optical axis of the blue LED array may be different from the travel direction of red light along the projection optical axis of the red lamp. Particularly in the red lamp 5 of FIG. 5, the travel direction of blue light along the emission optical axis (depicted by the dotted line) of blue LED array 51 is oriented backward (reverse) and oblique relative to the projection direction of red lamp 5. The red emissive member 52 is disposed forward in the travel direction of blue light along the emission optical axis of blue LED array 51.

FIG. 6 is a schematic view of a red lamp structure in a sixth embodiment of the invention. The red lamp 6 includes a base or reflector 60 of flat-bottom cylinder shape and a blue LED array 61 disposed on the bottom of base 60 and at the back side of the lamp 6 (which is opposite to the projection direction of red light). The blue LED array 61 includes six chips (emissive parts) 611 capable of emitting blue light forward of the lamp (in the projection direction of red light). The red lamp 6 further includes a red emissive member 62 in block form fitted within the base 60 so as to face the blue LED array 61 in the emission direction of blue light and having six recesses 621 for receiving the six chips 611, and a protective cover member 63 in plate form of arcuate cross section disposed further forward of the red emissive member 62 in the red light projection direction of the red lamp 6 (i.e. fitted within the base 60 at its rim).

The blue LED array 61 emits blue light, which mostly enters the red emissive member 62 directly. Blue light incident on the red emissive member 62 is absorbed by the phosphor in the red emissive member 62 and converted thereby to red component-containing light or red light. The red component-containing light or red light exiting the red emissive member 62 travels forward of the red lamp 6 directly or after reflection by the inner surface of base 60.

In the illustrated embodiment, the red emissive member 62 is of block shape, chips 611 of blue LED array 61 are disposed in recesses 621 of the red emissive member 62, and the red emissive member 62 receives blue light emitted by blue LED array 61. Little of the blue light emitted by the blue LED array 61 enters a portion other than the red emissive member 62. That is, almost all the blue light emitted by the blue LED array 61 enters the red emissive member 62 directly. The red emissive member 62 of block shape has a sufficient strength to be resistant to breakage or degradation.

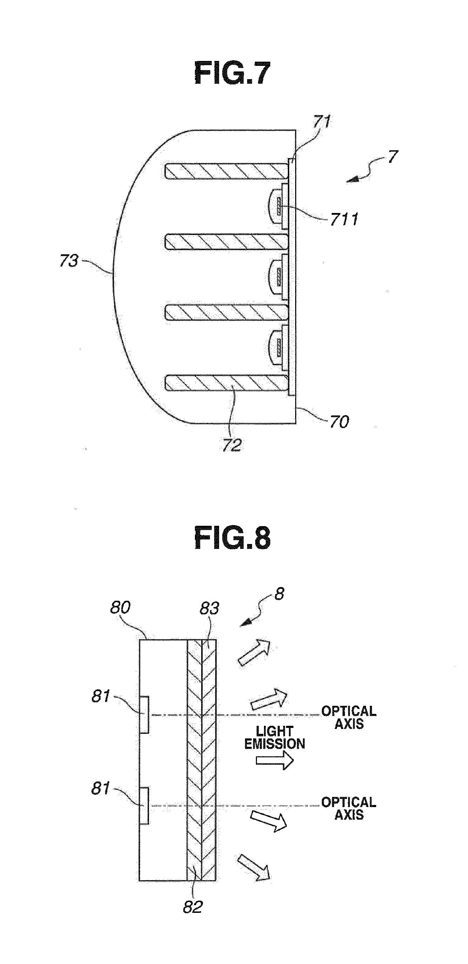

FIG. 7 is a schematic view of a red lamp structure in a seventh embodiment of the invention. The red lamp 7 includes a base or reflector 70 of plate form and a blue LED array 71 disposed on the inner surface of base 70 and at the back side of the lamp 7 (which is opposite to the projection direction of red light). The blue LED array 71 includes three chips (emissive parts) 711 capable of emitting blue light forward of the lamp (in the projection direction of red light). The red lamp 7 further includes four red emissive members 72 of plate shape disposed between chips 711 and outside chips 711 and extending from the base 70 to a front side of red lamp 7, and parallel to the emission optical axis of blue LED array 71, and a protective cover 73 of dome shape having a central area disposed further forward of red emissive members 72 in the red light projection direction of red lamp 7 and a rim fitted around base 70.

The blue LED array 71 emits blue light, which enters the red emissive members 72 directly or after reflection by the inner surface of the lamp (inner surface of base 70). Blue light incident on the red emissive members 72 is absorbed by the phosphor in the red emissive members 72 and converted thereby to red component-containing light or red light. The red component-containing light or red light exiting the red emissive members 72 travels forward of the red lamp 7 directly or after reflection by the inner surface of lamp 7.

In the illustrated embodiment, a plurality of red emissive members molded in plate or bar shape extend parallel to the emission optical axis of the blue LED array. A portion of blue light emitted by the blue LED array is directed forward of the red lamp while the remaining portion enters the red emissive members where it is converted to red component-containing light which is irradiated therefrom. A portion of blue light reflected or transmitted by one red emissive member enters another red emissive member where it is converted to red component-containing light which is irradiated therefrom. The red lamp structure of this embodiment is suited when a mixture of blue light and red light is desired.

In any of the structure embodiments, a protective cover is or may be provided for the purposes of further improving the visibility of red light (projected forward of the red lamp) from a backward position remote from the vehicle or a position forward in the projection direction of red light, improving the illuminance, aesthetic appearance, and internal protection. The protective cover may also have the function of lens and/or diffuser and be made red, white or transparent.

The intensity of red light projected forward of the red lamp may be properly selected depending on the number of chips (emissive parts), the number of blue LED arrays, electric current value, and the like. If it is desired to change the intensity of red light depending on whether the lamp is used as a rear position lamp or a stop lamp, the light intensity may be controlled as appropriate by changing the number of blue LED arrays to be lit and the electric current value.

For efficient utilization of light emitted by the blue LED array, in any of the structure embodiments a reflecting mirror or plate may be disposed on the back and/or lateral side of the red lamp so as to face the blue LED array. Also for efficiency, the reflecting mirror or plate may be disposed such that the red component exiting the red emissive member may travel in the projection direction of the red lamp.

For the purpose of improving the color purity at the red light emissive surface, the red lamp of the invention may be covered with a light-transmitting cover capable of reflecting or absorbing light other than red light and transmitting red light. This inhibits the possibility that the color of lamp emission changes from red light if a portion of blue light as excitation light exits the red lamp without being absorbed in the red emissive member. The light-transmitting cover may be a cover made of orange color transparent resin, for example, capable of reflecting or absorbing blue light and transmitting red light.

The structure of the red lamp is not limited to the above-illustrated structure embodiments as long as the lamp includes a blue LED array and a red emissive member such that red component exiting the red emissive member may be efficiently projected forward of the red lamp.

While the prior art rear position lamps and stop lamps use incandescent bulbs, halogen bulbs, HID lamps or red LEDs as the light source, these lamps are devised so as to enhance visibility by changing the direction of light from the light source and light reflected by the reflector via an optical diffuser or lens, or by setting a plurality of lamps in different directions. However, the former means has the drawback that on use of the diffuser or lens alone, the improvement in uniformity of visibility is limited, leaving bright and dark looking directions. The latter means has the drawback that an increased number of red LEDs lead to an increase of power consumption.

In contrast, red lamps embodying the invention can produce non-directional light because the light produced by the red lamp is light emitted by phosphor particles that have absorbed blue light, which light is usually emitted in all directions. Therefore, as long as the red emissive member is molded to a proper shape, the red lamp when operated produces light having high visibility in all directions. That is, a red lamp with uniformity of visibility is obtained. The red lamp has the advantage of reduced power consumption as compared with the prior art because the red emissive member can efficiently convert blue light to red component.

Also, by selecting the phosphor in the red emissive member to have an absorptance of blue light which is moderate rather than excessively high, not all blue light is absorbed in proximity to the surface of the red emissive member, and some blue light will reach the interior of red emissive member. This leads to the advantage that the red emissive member provides substantially uniform emission in its entirety. This advantage enables that the red emissive member molded to any desired shape be handled in its entirety as a single light source, and the red lamp be designed as a vehicle lighting fixture using a single light source, such as a red rear position lamp or stop lamp.

As the vehicle lighting fixture such as red rear position lamp or stop lamp, red lamps of diverse types using a linear light source, surface light source or 3D light source can be designed, without being bound to the design using a point light source as in the prior art. A higher freedom of design is allowed for the vehicle lighting fixture such as red rear position lamp or stop lamp, leaving a room for adopting new and innovative designs.

### EXAMPLE

Examples of the invention are given below by way of illustration and not by way of limitation.

### Example 1

A red lamp as shown in FIG. 8 was manufactured. FIG. 8 is a schematic view of a red lamp in an eighth embodiment of the invention. The red lamp 8 includes a base or reflector 80 of rectangular cross section transverse to the forward projection direction and having a flat closed bottom. Blue LED arrays 81 are disposed inside the bottom of base 80 and at the back of the red lamp 8 (opposite to the projection direction of red light), capable of emitting blue light forward of red lamp 8 (in the projection direction of red light). A red emissive member 82 of plate form is disposed at a front side of the red lamp 8 (or fitted within base 80) so as to face the emission direction of blue light from blue LED arrays 81. A protective cover (orange color transparent resin cover) 83 of plate form is disposed further forward in the red light projection direction of red lamp 8 and contiguous to the front surface of red emissive member 82. The protective cover allows for passage of red component (red light) exiting the red emissive member 82 and red component transmitted by the red emissive member 82 therethrough.

The blue LED arrays 81 emit blue light which enters the red emissive member 82 directly or after reflection by the inner surface of lamp 8 (or the inner surface of base 80). Blue light incident on the red emissive member 82 is absorbed by the phosphor therein and converted thereby to red component. Red component exiting the red emissive member 82 travels forward of the red lamp 8 directly or after reflection by the inner surface of lamp 8. In FIG. 8, thick arrows indicate some exemplary rays.

There were furnished two blue LED arrays each having a power of 1 W. The red emissive member was prepared by mixing polypropylene with 5% by weight of silicon nitride phosphor of (Sr,Ca)AlSiN₃:Eu (particle size: volume cumulative diameter D50 = 15 µm and D90 = 65 µm) as the red emissive material and molding the mixture into a body 40 mm long × 60 mm wide × 1 mm thick. The red emissive member was disposed at a distance of 20 mm from the front surface of the blue LED arrays and perpendicular to their optical axes (dotted lines in FIG. 8). The transparent filter/cover of orange color resin is disposed outside the red emissive member. The lamp base 80 was made of white color polyethylene.

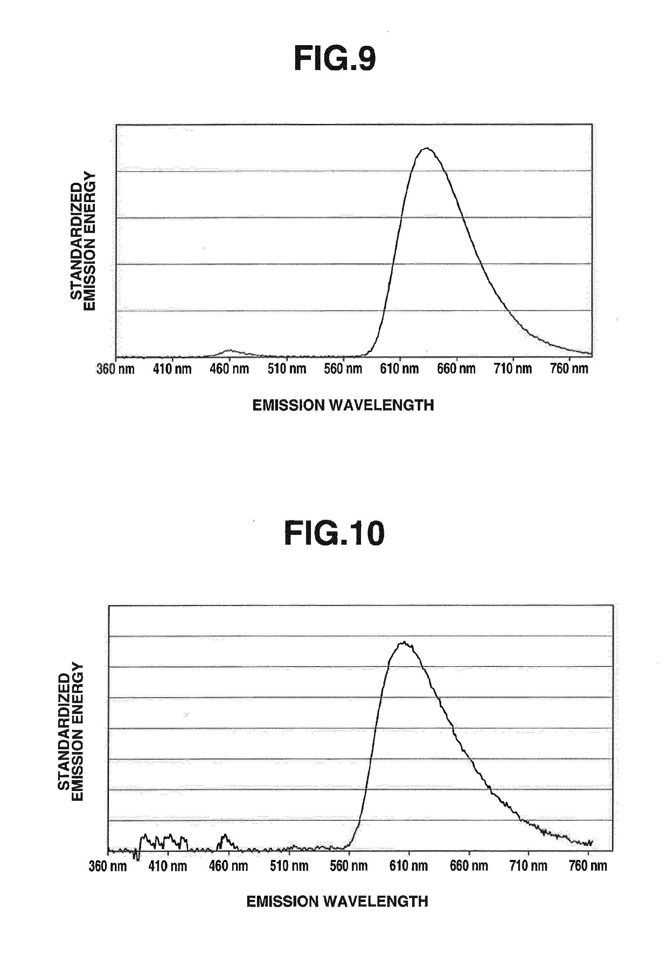

FIG. 9 shows the emission spectrum of the red lamp. The light produced by the red lamp was observed for chromaticity, luminance in front and lateral directions, and visibility. The light of emission had chromaticity values: × = 0.65 and y = 0.33 on the C.I.E. chromaticity coordinates, indicating satisfactory a chromatic hue as a red lamp. Also luminance in the front and lateral directions was measured. Provided that the red lamp has an optical axis of projection which is 0°, the luminance was measured in the range of 0° to 70°, with the data being shown in Table 1 as a value relative to the luminance at the optical axis of projection 0°. Only a small change was found in luminance between the front direction and the lateral direction, demonstrating that the red lamp had satisfactory visibility over a wide angle range. The visibility of the red lamp in daytime and night-time was confirmed at a distance of 300 meters away from the lamp, with the results shown in Table 2. Visibility in the front direction was satisfactory in either time zone. Visibility was also observed in an oblique direction of 45° relative to the projection optical axis of the red lamp, confirming satisfactory visibility as well.

### Example 2

A red lamp was manufactured as in Example 1 except that garnet structure phosphor of Y₃Al₅O₁₂:Ce (particle size: volume cumulative diameter D50 = 12 µm and D90 = 54 µm) was used as the red emissive material.

FIG. 10 shows the emission spectrum of the red lamp. The light produced by the red lamp was observed for chromaticity, luminance in front and lateral directions, and visibility. The light of emission had chromaticity values: x = 0.66 and y = 0.33 on the C.I.E. chromaticity coordinates, indicating satisfactory chromatic hue as a red lamp. Also luminance in the front and lateral directions was measured. Provided that the red lamp has an optical axis of projection which is 0°, the luminance was measured in the range of 0° to 70°, with the data being shown in Table 1 as a value relative to the luminance at the optical axis of projection 0°. Only a small change was found in luminance between the front direction and the lateral direction, demonstrating that the red lamp had satisfactory visibility over a wide angle range. The visibility of the red lamp in daytime and night-time was confirmed at a distance of 300 meters away from the lamp, with the results shown in Table 2. Visibility in the front direction was satisfactory in either time zone. Visibility was also observed in an oblique direction of 45° relative to the projection optical axis of the red lamp, confirming satisfactory visibility as well.

### Comparative Example 1

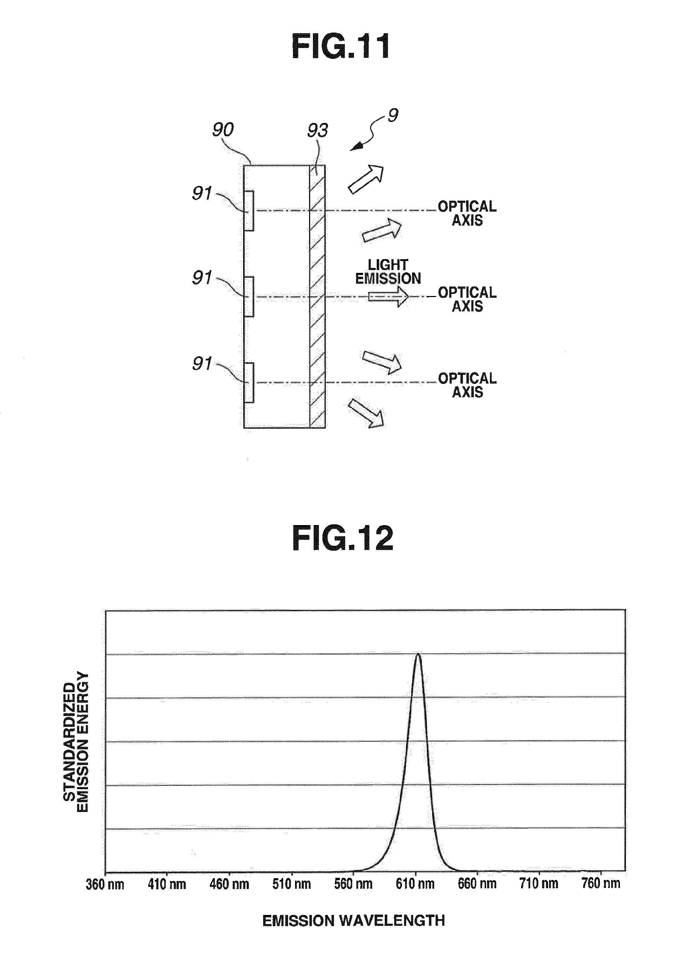

A red lamp as shown in FIG. 11 was manufactured. The lamp 9 of FIG. 11 is different from the lamp of FIG. 8 in that white LED arrays 91 were used as the light source, the red emissive member was omitted, and a red transparent acrylic resin plate of 2 mm thick was used as a filter 93. Also illustrated in FIG. 11 is a base or reflector 90. There were used two white LED arrays (CR-E by Cree, Inc.) each having a power of 1 W.

The light produced by the red lamp was observed for chromaticity, luminance in front and lateral directions, and visibility. The light of emission had chromaticity values: x = 0.66 and y = 0.32 on the C.I.E. chromaticity coordinates, indicating satisfactory chromatic hue as a red lamp. Also luminance in the front and lateral directions was measured. Provided that the red lamp has an optical axis of projection which is 0°, the luminance was measured in the range of 0° to 70°, with the data being shown in Table 1 as a value relative to the luminance at the optical axis of projection 0°. The luminance in the optical axis of projection was about 1.2 times that of Example 1, but the luminance in a lateral direction off the optical axis of projection, particularly in oblique directions of 50° or more from the optical axis of projection, was low. The emitted light was hardly visible in oblique directions. Light emission was spot-like or limited to the LED arrays, with intense glare being recognized. The visibility of the red lamp in daytime and night-time was confirmed at a distance of 300 meters away from the lamp, with the results shown in Table 2. Visibility in the front direction was satisfactory in cloudy daytime and fine night-time, but poor in sunny daytime and rainy night-time. Visibility in an oblique direction of 45° relative to the projection optical axis of the red lamp was poor at any time zones.

### Comparative Example 2

A red lamp as shown in FIG. 11 was manufactured. The lamp 9 is different from the lamp of FIG. 8 in that red LED arrays 91 were used as the light source, the red emissive member was omitted, and a colorless transparent resin plate of 2 mm thick was used as a protective cover 93. There were used four red LED arrays (NS6R083T by Nichia Corp.) each having an output power of 0.5 W.

FIG. 12 shows the emission spectrum of the red lamp. The light produced by the red lamp was observed for chromaticity, luminance in front and lateral directions, and visibility. The light of emission had chromaticity values: x = 0.70 and y = 0.30 on the C.I.E. chromaticity coordinates, indicating satisfactory chromatic hue as a red lamp. Also the luminance in front and lateral directions was measured. Provided that the red lamp has an optical axis of projection which is 0°, the luminance was measured in the range of 0° to 70°, with the data being shown in Table 1 as a value relative to the luminance at the optical axis of projection 0°. The luminance in the optical axis of projection was about 2.2 times that of Example 1, but the luminance in a lateral direction off the optical axis of projection, particularly in oblique directions at 40° or more from the optical axis of projection, was low. The emitted light was hardly visible in oblique directions. Light emission was spot-like or limited to the LED arrays, with intense glare being recognized. The visibility of the red lamp in daytime and night-time was confirmed at a distance of 300 meters away from the lamp, with the results shown in Table 2. Visibility in the front direction was satisfactory in sunny daytime, cloudy daytime and fine night-time, but poor in rainy night-time. Visibility in an oblique direction of 45° relative to the projection optical axis of the red lamp was poor at any time zones.

**Table 1**

| Angle (°) | 0 | 10 | 20 | 30 | 40 | 50 | 60 | 70 |
|---|---|---|---|---|---|---|---|---|
| Example 1 | 1 | 0.975 | 0.976 | 0.936 | 0.841 | 0.709 | 0.537 | 0.338 |
| Example 2 | 1 | 0.977 | 0.938 | 0.884 | 0.831 | 0.746 | 0.605 | 0.382 |
| Comparative Example 1 | 1 | 0.013 | 0.051 | 0.029 | 0.021 | 0.001 | 0.002 | 0.002 |
| Comparative Example 2 | 1 | 0.009 | 0.037 | 0.030 | 0.007 | 0.005 | 0.002 | 0.000 |

**Table 2**

| | Front direction in sunny daytime | 45° direction in sunny daytime | Front direction in cloudy daytime | 45° direction in cloudy daytime | Front direction in fine night-time | 45° direction in fine night-time | Front direction in rainy night-time | 45° direction in rainy night-time |
|---|---|---|---|---|---|---|---|---|
| Example 1 | satisfactory | satisfactory | satisfactory | satisfactory | satisfactory | satisfactory | satisfactory | satisfactory |
| Example 2 | satisfactory | satisfactory | satisfactory | satisfactory | satisfactory | satisfactory | satisfactory | satisfactory |
| Comparative Example 1 | somewhat poor | poor | satisfactory | poor | satisfactory | somewhat poor | poor | poor |
| Comparative Example 2 | satisfactory | poor | satisfactory | poor | satisfactory | poor | somewhat poor | poor |

## Claims

1. A red lamp comprising a blue LED array capable of emitting blue light as a light source and a red emissive member adapted to receive the blue light,
said red emissive member comprising a resin and a phosphor capable of absorbing blue light and emitting red component-containing light, said phosphor being at least one phosphor selected from silicate phosphors, SiAlON phosphors, silicon nitride phosphors, sulfide phosphors and garnet structure phosphors.

2. A red lamp of claim 1 wherein the resin is a thermoplastic resin.

3. A red lamp of claim 2 wherein the thermoplastic resin is at least one resin selected from polyethylene, polypropylene, polyester, polystyrene, polycarbonate, ABS resin and acrylic resin.

4. A red lamp of claim 1 wherein the resin is a thermosetting resin.

5. A red lamp of claim 4 wherein the thermosetting resin is at least one resin selected from phenolic resin, epoxy resin, melamine resin and urethane resin.

6. A red lamp of any one of claims 1 to 5 wherein a said phosphor is silicate phosphor (Sr,Ca,Ba)₂SiO₄:Eu, SiAlON phosphor Ca-α-SiAlON:Eu, silicon nitride phosphor (Sr,Ca)AlSiN₃:Eu, sulfide phosphor CaGa₂S₄:Eu or garnet structure phosphor (Y,Gd)₃Al₅O₁₂:Ce or Y₃Al₅O₁₂:Ce.

7. A red lamp of any one of claims 1 to 6, which projects red light along an optical path,
said red lamp further comprising a filter member disposed across the optical path for inhibiting a portion of the blue light from the blue LED array that is transmitted by the red emissive member without being absorbed in the phosphor, from traveling forward in the projection direction of the red lamp.

8. A red lamp of any one of claims 1 to 7, which projects red light along an optical axis, wherein
said blue LED array is disposed such that the travel direction of blue light along an emission optical axis of the blue LED array is different from the travel direction of red light along the projection optical axis of the red lamp, and
said red emissive member is disposed at least forward in the travel direction of blue light along the emission optical axis of the blue LED array.

9. A red lamp of any one of the preceding claims in which the red emissive member is in the form of a plate, film or bar.

10. A red lamp of any one of the preceding claims, wherein said red emissive member has a thickness of at least 0.5 mm at an effective region thereof.

11. A red lamp of any one of the preceding claims, for projecting red light in a forward direction of the lamp and comprising a base or reflector component, and in which
(i) the base/reflector component has a back side and a front side having a front rim, the blue LED array is mounted on an inner surface of the base/reflector component at the back of the lamp and the red emissive member is disposed in the base/reflector component in front of the blue LED array, optionally with a protective cover and/or red filter member in front of it;
(ii) the base/reflector component has a back side and a front side having a front rim, the red emissive member is disposed on the inside of the base/reflector component at the back of the lamp and the blue LED array is disposed in the base component, e.g. on the inner surface thereof near its front rim, to direct blue light backwardly onto the red emissive member, and optionally with a protective cover and/or red filter member in front of the blue LED array, or
(iii) the base/reflector component is of plate form at the back of the lamp, plural blue LED arrays or blue LED chips are disposed on its inner surface, plural said red emissive members in plate or bar form are disposed between the plural LEDs and extending forwardly from the base, and the lamp comprises a protective cover of dome shape and having a rim fitted to the base/reflector component.

12. A red lamp of claim 11(i) in which the red emissive member is in plate form, fitting at or adjacent the front of the base/reflector component or at an intermediate position therein, or is in the form of a block fitted at the back of the base/reflector component and having one or more recesses receiving the blue LED array(s) or chips thereof.

13. A vehicle lighting fixture comprising a red lamp of any one of claims 1 to 12.

14. A vehicle lighting fixture of claim 13, which is a red rear position lamp or red stop lamp.
